# EUROPEAN PATENT APPLICATION

(11) **EP 2 818 968 A1**
(43) Date of publication of application: **31.12.2014**
(21) Application number: 13751981.5
(22) Date of filing: 22.02.2013
(51) Int. Cl.: G06F 1/20

(54) **LOW-NOISE COMPUTER HEAT DISSIPATION DEVICE**

(30) Priority: 23.02.2012 CN 201220060220 U
(71) Applicant: Zhou, Zheming, Guangzhou, Guangdong 511447 (CN)
(72) Inventor: ZHOU, Zheming, Guangzhou Guangdong 511447 (CN); ZHOU, Faming, Guangzhou Guangdong 511447 (CN)
(74) Representative: Stuttard, Garry Philip
(86) International application number: PCT/CN2013/071804
(87) International publication number: WO 2013/123899

(57) **Abstract**

The present application discloses a low-noise computer heat dissipation device, which relates to electronic devices, and more particularly to the dissipation of heat generated by computer devices such as a server, a network device, a personal computer (PC), a notebook computer, etc. The computer heat dissipation device comprises a heat conduction member, a central radiator, and auxiliary heat dissipation fans. The heat conduction member is mainly formed by heat pipes, evaporation ends of the heat pipes are connected to main heating members inside a chassis, condensation ends of the heat pipes are connected to the central radiator, and the central radiator has cooling fins with large heat dissipation areas and a low-speed fan. The advantages of this technical solution are that noise of heat dissipation fans of the chassis can be reduced and the overall heat dissipation efficiency can be enhanced.

## Description

### TECHNICAL FIELD

The present application relates to electronic devices, and more particularly to the dissipation of heat generated by computer devices such as a server, a network device, a personal computer (PC), a notebook computer, etc.

### BACKGROUND

Currently, the most common heat dissipation method for computer chassis is to mount cooling fins and fans on main heating members inside the chassis for heat dissipation. The defect of this method is that the sizes of the cooling fins mounted on the members are limited by the layout of the members, the heating dissipation area is usually small, and therefore there is high requirement for the wind speeds of the heating dissipation fans, which causes continuous high rotation speeds of the fans and great noise. Furthermore, hot wind blown from the fans mounted on the heating members is prone to be inhaled by other fans, which may cause reduction of the overall heat dissipation efficiency.

### SUMMARY

In order to solve the problems in the prior art that the heat dissipation fans generate great noise and the overall heat dissipation efficiency reduces, the present application provides a low-noise computer heat dissipation device, wherein heat generated by main heating members inside a computer chassis is conducted to a central radiator, the central radiator dissipates the heat by cooling fins with large heat dissipation areas and a low-speed fan, and another low-speed fan is mounted in the chassis to assist the heat dissipation. The advantages of this solution are that noise of a heat dissipation fan of the chassis can be reduced and the overall heat dissipation efficiency can be enhanced.

In the present application, a technical solution for solving the technical problems is as follows.

A low-noise computer heat dissipation device comprises a heat conduction member, a central radiator, and auxiliary heat dissipation fans. The heat conduction member has one end connected to main heating members in a chassis, and another end connected to the central radiator.

The heat conduction member is mainly formed by heat pipes, evaporation ends of the heat pipes are connected to main heating members inside the chassis, wherein the main heating members include a CPU, a south bridge chip and a north bridge chip of a main board, a graphics card, a memory, a hard disk, a power supply, and other possible members, and condensation ends of the heat pipes are connected to the central radiator. In order to solve the problem that the heat conduction member may have many pipelines and be difficult to assemble, the heat conduction member can be formed by a plurality of heat pipes connected in series, and every two adjacent heat pipes are connected in series by metal boards welded on connection ends of the heat pipes and tightly contacting each other. In order to avoid thermal interference in the heat conduction member and protect the heat pipes, heat insulating material can be wrapped on the heat pipes.

The central radiator has cooling fins with large heat dissipation areas and a low-speed fan.

One embodiment of the central radiator is a water-cooling radiator, which includes a water-cooling plate, a water pipe, a water pump, a water storage tank, a radiator, a low-speed fan, and a water-resisting layer. The water-resisting layer is mounted in the chassis to divide the chassis into an inner cavity and an outer cavity, and the water-cooling radiator is mounted in the outer cavity and insulated from other devices in the chassis to prevent leak water from flowing to the devices in the chassis. The water-cooling plate is connected to the heat pipes of the heat conduction member, wherein one connection method is to weld heat dissipation plates on ends of the heat pipes, and the heat dissipation plates, the water-resisting layer, and the water-cooling plate contact each other in a stacking manner; and another connection method is to mount heat pipe sockets on a side surface of the water-cooling plate, sealing rings are mounted in the heat pipe sockets, and the heat pipes of the heat conduction member run through the water-resisting layer and are inserted into the water-cooling plate via the heat pipe sockets to contact cooling water, so that heat of the heat pipes can be directly exchanged into the cooling water. There can be a plurality of water-cooling plates connected to nearby heat pipes of the heat conduction member respectively.

Another embodiment of the central radiator is a heat pipe radiator, which includes a heat conducting plate, heat pipes, cooling fins, and a low-speed fan. The heat conducting plate is connected to the heat pipes of the heat conduction member, that is, heat dissipation plates are welded on ends of the heat pipes of the heat conduction member, and the heat dissipation plates contact the heat conducting plate.

Some of the auxiliary heat dissipation fans in the chassis are mounted near the main heating members to exchange excessive heat of the main heating members into the air in the chassis, and the others are mounted on the housing of the chassis to dissipate hot air in the chassis to the outside of the chassis.

The advantages of the present application are that noise of heat dissipation fans of the chassis can be reduced and the overall heat dissipation efficiency can be enhanced.

### BRIEF DESCRIPTION OF THE DRAWINGS

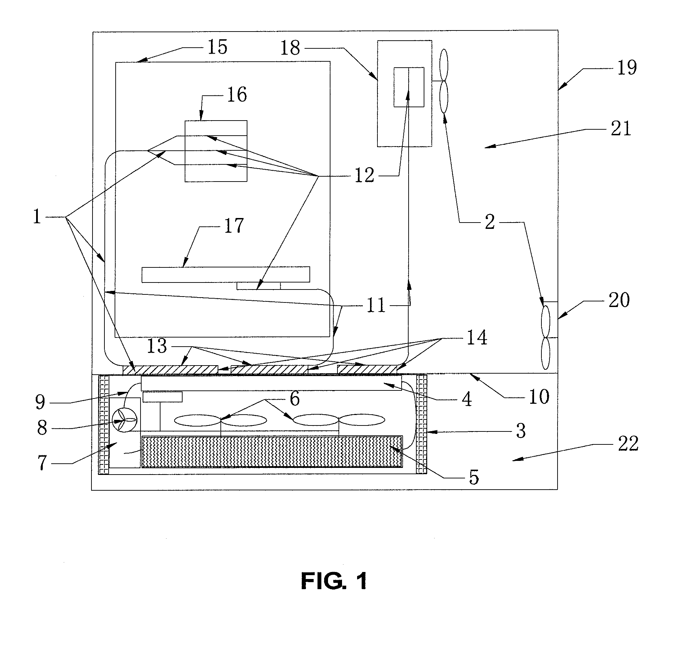

Figure 1 is a structural schematic view of a PC chassis according to the present application;
1: heat conduction member; 2: auxiliary heat dissipation fan; 3: central radiator; 4: water-cooling plate; 5: radiator; 6: low-speed fan; 7: water storage tank; 8: water pump; 9: water pipe; 10: water-resisting layer; 11: heat pipe; 12: evaporation end; 13: condensation end; 14: heat dissipation plate; 15: main board; 16: CPU; 17: graphics card; 18: power supply; 19: chassis housing; 20: opening portion of the housing of the chassis; 21: inner cavity; 22: outer cavity.

### DETAILED DESCRIPTION

The following accompanying drawings and embodiments of the present application will be further described.

In Figure 1, one embodiment of the present application is a PC chassis.

As shown in Figure 1, the PC chassis includes a chassis housing 19, and a heat conduction member 1, auxiliary heat dissipation fans 2, and a central radiator 3 inside the chassis. The heat conduction member 1 is mainly formed by heat pipes 11, evaporation ends 12 of the heat pipes 11 are connected to main heating members, such as a CPU 16, a graphics card 17, and a power supply 18 in the chassis, and heat dissipation plates 14 are welded on condensation ends 13 of the heat pipes 11. The central radiator 3 is a water-cooling radiator, and includes a water-cooling plate 4, a radiator 5, a low-speed fan 6, a water storage tank 7, a water pump 8, a water pipe 9, and a water-resisting layer 10. The water-resisting layer 10 is mounted in the chassis to divide the chassis into an inner cavity 21 and an outer cavity 22, the central radiator 3 is mounted in the outer cavity 22. The heat dissipation plates 14, the water-resisting layer 10, and the water-cooling plate 4 contact each other in a stacking manner.

Some of the auxiliary heat dissipation fans 2 in the chassis are mounted near the main heating members to exchange excessive heat of the main heating members into the air in the chassis, and the others are mounted on an opening portion 20 of the housing of the chassis to dissipate hot air in the chassis to the outside of the chassis.

## Claims

1. A low-noise computer heat dissipation device, **characterized in that** the low-noise computer heat dissipation device includes a heat conduction member, a central radiator, and auxiliary heat dissipation fans; one end of the heat conduction member is connected to main heating members in a chassis, and another end of the heat conduction member is connected to the central radiator; and the heat conduction member is mainly formed by heat pipes.

2. The low-noise computer heat dissipation device according to claim 1, **characterized in that** the heat pipes of the heat conduction member are connected in series by metal boards welded on ends of the heat pipes and tightly contacting each other, and heat insulating material is wrapped on the heat pipes.

3. The low-noise computer heat dissipation device according to claim 1 or 2, **characterized in that** the central radiator is a water-cooling radiator, and the central radiator includes a water-cooling plate, a water pipe, a water pump, a water storage tank, a radiator, a low-speed fan, and a water-resisting layer; the water-resisting layer is mounted in the chassis to divide the chassis into an inner cavity and an outer cavity, and the water-cooling radiator is mounted in the outer cavity and insulated from other devices in the chassis.

4. The low-noise computer heat dissipation device according to claim 3, **characterized in that** the water-cooling plate of the central radiator is connected to the heat pipes of the heat conduction member by a connection method that heat dissipation plates are welded on the heat pipes, and the heat dissipation plates, the water-resisting layer, and the water-cooling plate contact each other in a stacking manner.

5. The low-noise computer heat dissipation device according to claim 3, **characterized in that** the water-cooling plate of the central radiator is connected to the heat pipes of the heat conduction member by a connection method that heat pipe sockets with sealing rings are mounted on a side surface of the water-cooling plate, the heat pipes of the heat conduction member run through the water-resisting layer and are inserted into the water-cooling plate via the heat pipe sockets to contact cooling water; and there are a plurality of water-cooling plates connected to nearby heat pipes of the heat conduction member respectively.

6. The low-noise computer heat dissipation device according to claim 1 or 2, **characterized in that** the central radiator is a heat pipe radiator and includes a heat conducting plate, heat pipes, cooling fins, and a low-speed fan, and the heat conducting plate contacts heat dissipation plates welded on ends of the heat pipes of the heat conduction member.

7. The low-noise computer heat dissipation device according to claim 1 or 2, **characterized in that** some of the auxiliary heat dissipation fans are mounted near the main heating members, and the others are mounted on an opening portion of a housing of the chassis.
